# FASCICULE DE BREVET EUROPEEN

(11) **EP 1 421 623 B1**
(45) Date de publication et mention de la délivrance du brevet: **17.10.2007**
(21) Numéro de dépôt: 02796332.1
(22) Date de dépôt: 30.08.2002
(51) Int. Cl.: H01L 27/146, H01L 31/0216

(54) **CAPTEUR D'IMAGE COULEUR A COLORIMETRIE AMELIOREE ET PROCEDE DE FABRICATION**
FARBBILDSENSOR MIT VERBESSERTER KALORIMETRIE UND VERFAHREN ZU SEINER HERSTELLUNG
COLOUR IMAGE SENSOR WITH ENHANCED CALORIMETRY AND METHOD FOR MAKING SAME

(30) Priorité: 31.08.2001 FR 0111334
(43) Date de publication de la demande: 26.05.2004
(73) Titulaire: E2V SEMICONDUCTORS, 38120 Saint Egreve (FR)
(72) Inventeur: POURQUIER, Eric, Thales Intellectual Property, F-94117 Arcueil Cedex (FR); BRISSOT, Louis, Thales Intellectual Property, F-94117 Arcueil Cedex (FR); SIMON, Gilles, Thales Intellectual Property, F-94117 Arcueil Cedex (FR); JUTANT, Alain, Thales Intellectual Property, F-94117 Arcueil Cedex (FR); ROMMEVEAUX, Philippe, Thales Intellectual Property, F-94117 Arcueil Cedex (FR)
(74) Mandataire: Guérin, Michel
(86) Numéro de dépôt international: PCT/FR2002/002978
(87) Numéro de publication internationale: WO 2003/019668

(56) Documents cités:
- US-A- 5 244 817
- US-A- 5 274 250
- US-A- 5 568 574
- US-A- 6 091 194
- US-B1- 6 257 491

## Description

L'invention concerne les capteurs d'image électroniques, et notamment les capteurs de très petites dimensions permettant de réaliser des caméras miniatures, telles que celles qu'on peut vouloir incorporer à un téléphone portable.

Pour ce type d'application, il est nécessaire de réaliser l'ensemble de la caméra par des procédés les plus économiques possibles pour ne pas aboutir à un coût rédhibitoire de l'appareil, puisque celui-ci est a priori destiné à une vente au grand public.

Pour y parvenir, on essaye d'une part de réaliser le capteur d'image et les circuits électroniques de traitement si possible sur un même substrat semiconducteur monocristallin (en principe du silicium), et, d'autre part, on essaye de réaliser autant que possible les dépôts de couches diverses, les gravures, les traitements thermiques, etc. d'une manière collective sur un substrat global en forme de tranche (ou "wafer") comportant de nombreux capteurs identiques, avant de découper la tranche en capteurs individuels. Typiquement, une tranche de silicium comportera plusieurs milliers de puces individuelles constituant chacune le coeur d'un capteur d'image donc d'une caméra.

Cependant, les procédés de fabrication et structures de capteur d'image en couleur qui ont été proposés jusqu'à maintenant ne donnent pas entièrement satisfaction du point de vue du rapport qualité/coùt de fabrication : on n'a pas trouvé de procédé de fabrication qui soit à la fois suffisamment simple, industriellement efficace, et compatible avec des exigences de plus en plus élevées sur la qualité de l'image fournie. Une des exigences est en particulier la qualité de la colorimétrie, déterminée en particulier par la séparation nette des faisceaux lumineux entre points photosensibles voisins recouverts de filtres de couleurs différentes.

Un capteur d'image en couleur est réalisé classiquement de la manière suivante : on part d'une tranche de silicium sur la face avant de laquelle on effectue des opérations de masquage, d'implantation d'impuretés, de dépôt de couches de composition diverses provisoires ou définitives, de gravures de ces couches, de traitements thermiques, etc. ; ces opérations permettent de définir-une matrice de points photosensibles et des circuits de traitement de signaux électriques associés à ces points ; puis on dépose sur la face avant de la tranche de silicium des couches de filtrage colorées que l'on grave individuellement pour définir un motif matriciel : la matrice comprend, en ligne et en colonne, des groupes de trois ou quatre filtres juxtaposés de couleurs différentes pour chaque point d'image du capteur. Chaque filtre élémentaire est situé au-dessus d'une zone photosensible respective recevant la lumière d'une seule couleur. Les filtres immédiatement adjacents, au-dessus de zones photosensibles immédiatement adjacentes, ont des couleurs différentes. Enfin, on découpe la tranche de silicium en puces constituant chacune un capteur d'image couleur individuel.

Les filtres colorés sont placés au-dessus des couches isolantes, conductrices et semiconductrices qui ont servi à définir les points photosensibles et leurs interconnexions. Ils sont à une distance de plusieurs micromètres au-dessus des zones de silicium qui convertissent les photons lumineux en électrons. Cette distance verticale est non négligeable au regard des dimensions horizontales d'un point photosensible et elle induit le phénomène suivant : des photons ayant traversé un filtre coloré n'atteignent pas immédiatement la zone photosensible correspondant à ce filtre ; dans le trajet qui reste à parcourir après le filtre de couleur, ils peuvent être dispersés, subir des réfractions, des réflexions, etc. Il en résulte qu'une partie des photons peut atteindre une zone photosensible voisine. Si on travaillait en lumière monochrome, cela n'aurait pas grande importance : il en résulterait une légère perte de résolution spatiale qui n'affecterait que les zones d'image contenant des fréquences spatiales élevées. Mais dans une caméra couleur, le problème est beaucoup plus critique car même des zones d'image n'ayant que des fréquences spatiales faibles (par exemple une zone d'image de couleur rouge uniforme) sont très affectées : la couleur est détériorée systématiquement puisque les pixels correspondant aux autres couleurs reçoivent systématiquement une fraction de flux lumineux qui ne leur est pas destinée. La qualité de la colorimétrie est donc particulièrement affectée par la dispersion de la lumière dans l'intervalle qui sépare le filtre coloré et la zone photosensible qui lui correspond.

Ce problème est particulièrement critique dans les technologies de capteurs d'image CMOS. Cette technologie, à base de photodiodes comme éléments photosensibles, est de plus en plus utilisée car elle permet de réaliser sur une même puce de circuit intégré à la fois le capteur d'image (matrice de points photosensibles) et des circuits de commande et de traitement de signal associés. Or cette technologie requiert le dépôt de multiples couches diélectriques et métalliques au-dessus du niveau de silicium dans lequel sont réalisées les zones photosensibles proprement dites. Il en résulte que les filtres colorés déposés au-dessus de cet empilement sont particulièrement éloignés des zones photosensibles, et le phénomène de détérioration de la colorimétrie est particulièrement marqué. La hauteur de l'empilement atteint dans ce cas facilement une dizaine de micromètres.

La présente invention a pour but de proposer un procédé de fabrication et une structure de capteur d'image en couleur qui améliorent notablement, au prix d'un accroissement faible mais acceptable de la complexité de réalisation, la qualité colorimétrique des images obtenues, sans nuire à d'autres qualités telles que la sensibilité en lumière faible et l'encombrement réduit.

A cet effet, l'invention propose un procédé de fabrication d'un capteur d'image en couleur, comprenant :
- la formation, sur la face avant d'une tranche semiconductrice, d'une série de zones actives comportant des circuits de détection d'image et correspondant chacune à un capteur d'image respectif, chaque zone active comprenant des zones photosensibles recouvertes de couches isolantes et conductrices permettant le recueil de charges électriques générées dans les zones photosensibles,
- le report de la tranche par sa face avant contre la face avant d'un substrat de support,
- l'élimination de la majeure partie de l'épaisseur de la tranche semiconductrice, laissant subsister sur le substrat une fine couche semiconductrice comprenant les zones photosensibles, l'épaisseur de la tranche semiconductrice après amincissement étant d'environ 8 à 30 micromètres, incluant l'épaisseur de l'empilement de couches conductrices (14) et isolantes (16),
- et, ultérieurement, le dépôt et la gravure, sur la couche semiconductrice ainsi amincie, de filtres de couleur.

On comprend qu'avec ce procédé, les filtres de couleur ne se trouvent plus au-dessus de l'empilement de couches isolantes et conductrices qui ont pu être déposées (en technologie CMOS ou une autre technologie) sur les zones photosensibles au cours de la fabrication de la tranche semiconductrice. Bien au contraire, les filtres sont placés au-dessous des zones photosensibles, à l'opposé des couches isolantes et conductrices qui se trouvent alors de l'autre côté des zones photosensibles. Cela veut dire que dans l'utilisation du capteur dans une caméra, la lumière traversera les filtres colorés et atteindra directement les zones photosensibles sans avoir à traverser l'empilement de couches isolantes et conductrices.

Ce procédé de fabrication requiert un report d'une tranche semiconductrice sur un substrat et un amincissement de la tranche semiconductrice. Les techniques de report et d'amincissement sont de mieux en mieux maîtrisées de sorte que le surcoût de l'opération sera acceptable pour une qualité d'image notablement améliorée.

L'encombrement du capteur (puisqu'on veut faire des capteurs de très petites dimensions) n'est pas détérioré et la sensibilité en faible lumière en est même améliorée.

Le capteur d'image selon l'invention comprend donc essentiellement, sur un substrat de support, un ensemble superposé comprenant d'une part une couche semiconductrice très mince dans laquelle on a formé un réseau matriciel de zones photosensibles et d'autre part un empilement de couches gravées isolantes et conductrices permettant le recueil de charges électriques générées par la lumière dans chacune des zones photosensibles, et il est caractérisé par le fait que des filtres de couleur sont déposés sur cet ensemble superposé, du côté de la couche semiconductrice très mince de manière que la lumière passe dans l'ordre à travers les filtres de couleur, puis dans les zones semiconductrices photosensibles, avant d'atteindre l'empilement de couches isolantes et conductrices, sans rencontrer un réseau desdites couches conductrices avant d'atteindre le réseau de zones photosensibles, la couche semiconductrice ayant une épaisseur d'environ 3 à 20 micromètres au-dessus de l'empilement de couches conductrices et isolantes.

Le report de la tranche semiconductrice peut se faire par collage, par soudure classique, par soudure anodique (connue sous l'appellation anglo-saxonne "anodic bonding"), ou par simple adhérence moléculaire (force de contact très élevée entre deux surfaces de grande planéité).

L'amincissement de la tranche après report sur le substrat et avant dépôt des filtres colorés peut se faire de plusieurs manières différentes : amincissement par rodage, amincissement chimique, combinaison des deux types (d'abord mécanique puis finition chimique, ou bien usinage mécanique en présence de produits chimiques) ; on peut aussi procéder à l'amincissement par fragilisation préalable de la tranche au niveau du plan de coupe désiré, notamment par implantation d'hydrogène en profondeur dans le plan de découpe désiré. Dans ce dernier cas, l'implantation d'hydrogène est faite à faible profondeur dans la tranche semiconductrice avant le report de la tranche sur le substrat. L'amincissement est fait ensuite par un traitement thermique qui dissocie la tranche au niveau du plan de découpe implanté, laissant une fine couche semiconductrice en contact avec le substrat.

L'amincissement très important de la tranche, fait passer l'épaisseur de celle-ci de plusieurs centaines de micromètres avant report sur le substrat à 3 à 20 micromètres après report sur le substrat.

De préférence, la puce de circuit intégré correspondant à un capteur individuel comprend à la fois une matrice d'éléments photosensibles, des circuits de commande de la matrice, et des circuits de traitement d'image associés recevant des signaux issus des éléments photosensibles de la zone active. Les circuits ainsi associés à la matrice sont de préférence masqués contre la lumière par une couche d'aluminium, seule la matrice étant exposée à la lumière.

Dans un mode de réalisation particulier, on forme sur le substrat de support, préalablement au report de la tranche semiconductrice, des vias métallisés disposés avec la même géométrie que des plots de connexion formés sur la tranche semiconductrice autour de chaque zone active (donc à la périphérie de chaque capteur d'image individuel). Lors du report, les plots de connexion viennent en contact avec les vias métallisés, et des connexions vers l'extérieur peuvent être faites à l'arrière du substrat de support. Les capteurs d'image peuvent d'ailleurs être testés sur tranche, avant découpe en capteurs individuels après les opérations de report, d'amincissement, de dépôt et de gravure de filtres colorés.

La tranche semiconductrice est de préférence en silicium. Le substrat de support peut être en silicium. Il peut aussi être réalisé en un autre matériau dont le coefficient de dilatation est compatible avec celui du silicium pour ne pas créer de contraintes excessives lors des variations de température auxquelles la structure tranche/substrat est soumise.

Le document US-A-5 244 817 décrit un capteur aminci pour des images non colorées.

Le document US-B1-6 257 491 décrit un module optique pour scanner.

Le document US-A-5 274 250 décrit un capteur non aminci à éclairement par la face avant.

Le document US-A-6 091 194 décrit un afficheur.

D'autres caractéristiques et avantages de l'invention apparaîtront à la lecture de la description détaillée qui suit et qui est faite en référence aux dessins annexés dans lesquels :
- la figure 1 représente un capteur d'image couleur CMOS classique ;
- la figure 2 représente un capteur d'image couleur selon l'invention ;
- la figure 3 représente un mode de réalisation particulier du capteur selon l'invention avec une couche de protection transparente au-dessus des filtres colorés ;
- la figure 4 représente un mode de connexion possible du capteur avec l'extérieur, par des puits d'accès métallisés formés dans la tranche de silicium avant report sur le substrat de support ;
- la figure 5 représente un autre mode de connexion possible avec des vias métallisés formés dans le substrat de support avant report de la tranche ;
- la figure 6 représente encore un autre mode de connexion possible, avec des puits d'accès métallisés formés après l'opération d'amincissement;
- la figure 7 représente une variante de réalisation du capteur selon l'invention, dans laquelle un substrat définitif est transparent, les filtres colorés étant situés entre le substrat transparent et la couche de silicium amincie ;
- les figures 8 à 12 représentent les différentes étapes de réalisation du capteur dans un exemple pratique correspondant à la réalisation de la figure 5.

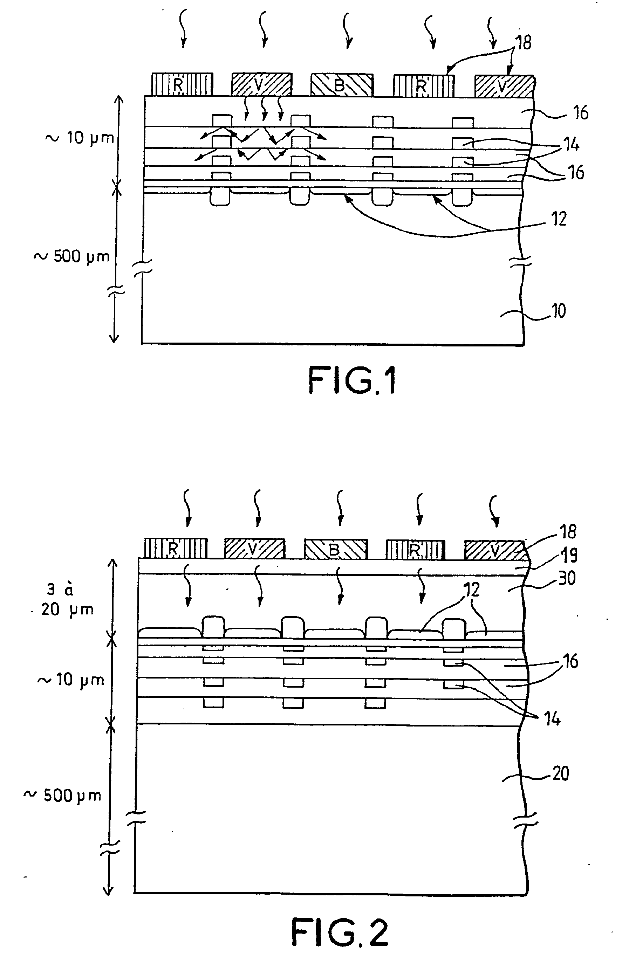

La figure 1 rappelle succinctement le principe d'un capteur d'image en couleur de l'art antérieur. Le capteur est réalisé sur un substrat de silicium 10 dont l'épaisseur est de plusieurs centaines de micromètres, cette épaisseur étant celle de la tranche de silicium sur laquelle est fabriquée simultanément une multiplicité de capteurs d'image individuels.

Les circuits de détection d'image (matrice de points photosensibles, transistors, interconnexions) sont fabriqués sur une face de la tranche de silicium, qu'on peut appeler face avant et qui est la face supérieure sur la figure 1. La fabrication implique d'une part des diffusions et implantations diverses dans le silicium, à partir de la face supérieure de la tranche, pour former notamment des zones photosensibles 12, et d'autre part des dépôts et gravures successives de couches conductrices 14 et de couches isolantes 16 formant un empilement au-dessus des zones photosensibles 12. Les couches isolantes et conductrices font partie des circuits de détection d'image et permettent le recueil des charges électriques engendrées dans les zones photosensibles par une image projetée sur le capteur.

Au-dessus de l'empilement de couches conductrices et isolantes est disposé un réseau matriciel de filtres colorés 18 pour qu'à chaque zone photosensible individuelle 12 corresponde un filtre coloré particulier 18, la zone photosensible 12 ne recevant en principe que la lumière qui a traversé le filtre coloré correspondant. Les zones photosensibles adjacentes correspondent à des couleurs différentes, par exemple rouge, vert, bleu ou cyan, magenta et jaune, et un point d'image trichrome correspond à trois (parfois quatre) filtres colorés adjacents.

Lors de l'utilisation, la lumière modulée par l'image à détecter arrive sur les filtres, traverse les couches conductrices et isolantes et arrive sur les zones photosensibles.

Les couches isolantes sont en principe bien transparentes, mais les couches conductrices sont le plus souvent opaques et réfléchissantes ; la zone photosensible proprement dite n'est donc pas placée au-dessous de portions de couches conductrices et la lumière arrive directement sur la zone photosensible après passage dans les filtres colorés et les couches isolantes.

Toutefois, la multiplicité de couches isolantes superposées et la présence de couches conductrices le plus souvent en aluminium sur les côtés, crée de multiples réfractions et réflexions qui dévient une partie de la lumière issue d'un filtre coloré vers les zones photosensibles qui ne correspondent pas à ce filtre. Un pourcentage même faible de lumière ainsi déviée crée une dégradation forte des performances colorimétriques du capteur.

La figure 2 représente le capteur selon l'invention. Il comprend un substrat 20 qui porte d'abord un ensemble superposé de deux groupes de couches. L'un des groupes, porté dans la réalisation de la figure 2 directement sur le substrat 20, est un empilement de couches conductrices 14 et isolantes 16, analogue à l'empilement de couches conductrices et isolantes 14 et 16 de la figure 1 mais disposées en sens inverse. Cet empilement peut avoir une dizaine de micromètres d'épaisseur. Le deuxième groupe de couches comprend une couche de silicium très mince 30 (3 micromètres à 20 micromètres d'épaisseur environ) dans laquelle on a formé par implantation et/ou diffusion d'impuretés des zones photosensibles 12. Les couches conductrices et isolantes 14 et 16 définissent des circuits électriques permettant le recueil de charges électriques générées par la lumière dans les zones photosensibles 12. L'ensemble des zones 12, des couches 14 et des couches 16 est analogue à celui de la figure 1, mais disposé à l'envers, c'est-à-dire tourné vers le bas.

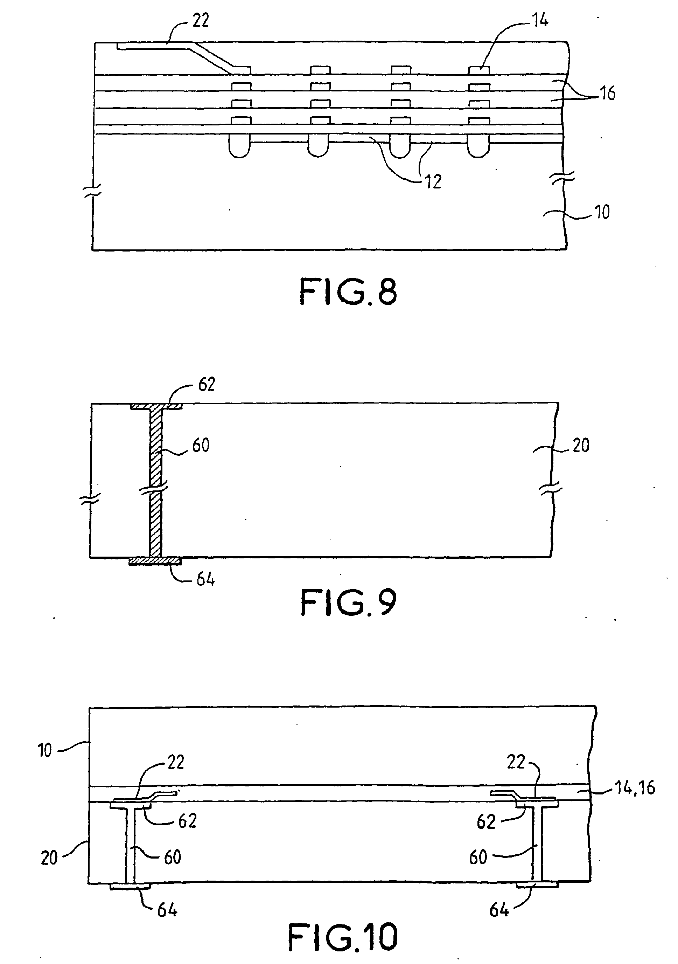

Des filtres de couleur 18 sont déposés sur la couche de silicium très mince 30, à l'opposé des couches conductrices et isolantes, de manière que la lumière passe dans l'ordre à travers les filtres colorés, puis dans les zones de silicium photosensibles, puis éventuellement dans les couches isolantes et conductrices. On verra que la réalisation de la figure 8 comporte un empilement différent de celui de la figure 2 en ce sens que le substrat, qui est alors transparent, porte d'abord les filtres colorés puis la couche de silicium très mince, puis l'empilement de couches isolantes et conductrices, mais les filtres colorés sont encore à l'opposé de l'empilement de couches isolantes et conductrices et adjacents à la couche de silicium très mince contrairement à ce qu'on voit sur la figure 1.

Par conséquent, d'une manière générale, il n'y a pas, au dessus des zones photosensibles 12, entre le plan de ces zones et le plan des filtres colorés, de réseau de conducteurs électriques de liaison. Tous les réseaux de conducteurs gravés assurant le fonctionnement de la matrice photosensible sont au dessous des zones photosensibles et des filtres colorés qui les recouvrent.

Les photons qui traversent un filtre coloré 18 sont absorbés dans la couche de silicium très mince 30 et produisent des charges électriques recueillies dans la zone photosensible 12 (en pratique une photodiode) située au-dessous du filtre coloré. Les charges électriques sont recueillies par les conducteurs de l'empilement situé au-dessous de la zone photosensible. Cet empilement de couches isolantes et conductrices ne constitue pas un obstacle aux photons et ne crée donc pas de déviation vers les zones photosensibles voisines. Seuls les photons non absorbés par la couche de silicium 30 se perdent dans ces couches.

Le procédé de fabrication du capteur de la figure 2 consiste globalement à préparer une tranche de silicium exactement comme pour fabriquer un capteur traditionnel tel que celui de la figure 1, à l'exception de la mise en place des filtres colorés. Ensuite, cette tranche est rapportée sur une autre tranche, ou tranche de support, qui va constituer le substrat 20. Dans cette opération, la face avant de la tranche de silicium portant les circuits photosensibles est appliquée contre la tranche de support (qu'on peut désigner par 20 puisqu'elle constitue le substrat 20 de la figure 2). On travaille à ce stade sur tranches (150 à 300 mm de diamètre par exemple) et non sur des capteurs individuels.

Il est préférable de rendre bien plane la face avant de la tranche de silicium avant l'opération de report, étant donné que les opérations de dépôt et gravure de l'empilement de couches isolantes et conductrices 14, 16 ont créé un relief sur cette face. Cette "planarisation" est faite classiquement par dépôt d'une couche isolante remplissant les creux du relief. Cette couche de planarisation n'a pas besoin d'être transparente.

Le report de la tranche de silicium sur la tranche de support 20 peut se faire par plusieurs moyens, le moyen le plus simple pouvant être tout simplement un maintien par adhérence moléculaire, la grande planéité des surfaces en contact engendrant des forces de contact très élevées. Un collage est possible également. Comme on le verra plus loin, on peut aussi établir une liaison mécanique et électrique entre des plots de contact de la tranche de silicium et des plots de contact correspondants de la tranche de support 20 par l'intermédiaire de bossages métalliques ou organiques conducteurs.

Après report de la tranche de silicium par sa face avant sur la tranche de support, on élimine la majeure partie de l'épaisseur de la tranche de silicium pour n'en laisser subsister qu'une épaisseur d'environ 8 à 30 micromètres, incluant l'épaisseur de l'empilement de couches. Ce qui subsiste de la tranche de silicium n'est plus qu'une superposition de quelques micromètres (de 5 à 10 par exemple) pour l'empilement de couches 14, 16 et environ 3 à 20 micromètres pour l'épaisseur de silicium subsistante, incluant les zones photosensibles 12. L'épaisseur subsistante est la couche 30 de la figure 2.

L'opération d'amincissement peut se faire par usinage mécanique (rodage) terminé par un usinage chimique, ou par usinage mécano-chimique, ou par usinage chimique uniquement, ou encore par un procédé de séparation particulier nécessitant au préalable une implantation d'une impureté de fragilisation dans le plan qui délimitera la couche de silicium amincie.

Dans le cas de cette séparation par implantation d'impuretés, il faut effectuer l'implantation avant le report de la tranche de silicium sur la tranche de support. En effet, l'implantation se fait par la face avant de la tranche de silicium, sur toute la surface de celle-ci et à une profondeur qui définira le plan de découpe. L'implantation préalable est de préférence une implantation d'hydrogène. Elle peut être effectuée à divers stades de la fabrication de la tranche, mais la séparation de l'épaisseur de la tranche selon le plan de découpe implanté ne se fait que lorsque la tranche de silicium a été rapportée sur la tranche de support. Cette séparation se fait essentiellement par un traitement thermique engendrant des contraintes qui divisent la tranche en deux selon le plan de découpe pré-implanté.

La surface supérieure de la couche de silicium amincie 30 peut être traitée (rodage fin, nettoyage chimique, polissage mécano-chimique, etc.) pour éliminer les défauts de surface, après quoi les filtres colorés peuvent être déposés et gravés, aboutissant à une tranche de multiples capteurs dont la structure générale est celle de la figure 2. Si on le souhaite, on peut déposer une ou plusieurs couches supplémentaires avant dépôt des filtres colorés, et notamment des couches de passivation, des couches antireflet et d'autres couches, par exemple des couches nécessaires à l'activation électrique des couches de silicium dopées (couches de polarisation électrique). Ces couches supplémentaires sont désignées par la référence 19 sur la figure 2 et ne sont pas représentées sur les autres figures.

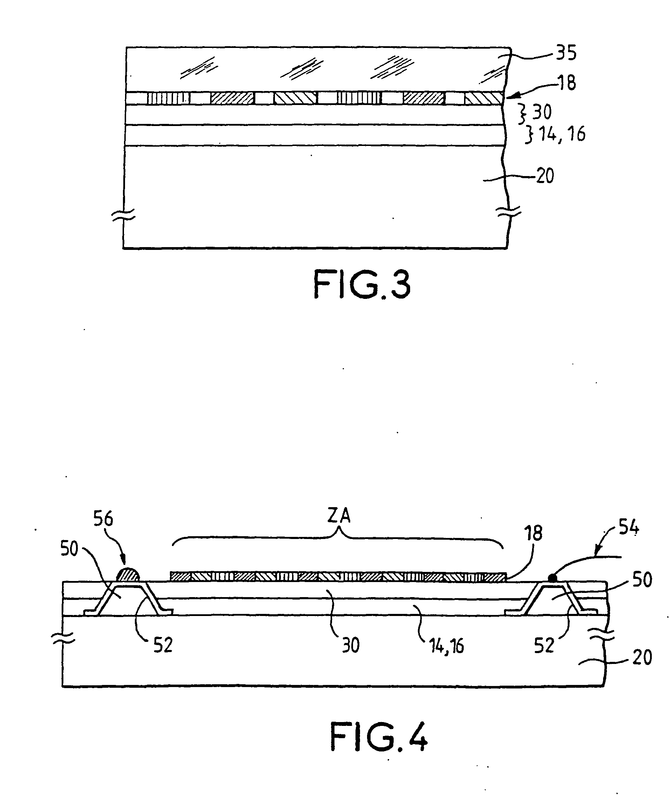

La figure 3 représente une réalisation dans laquelle, partant de la figure 2, on a disposé en outre une couche transparente 35 sur toute la surface du capteur. Cette couche 35, en verre ou en matière plastique transparente, est appliquée étroitement contre la surface qui porte les filtres. Elle absorbe peu les photons et protège la surface des filtres colorés et le silicium qui est au-dessous. Cette couche peut avoir une épaisseur de quelques micromètres à quelques centaines de micromètres. Une couche de planarisation peut être déposée sur les filtres colorés avant dépôt de la couche 35 pour faire disparaître les irrégularités de relief dues aux filtres colorés.

Il faut noter ici que la couche transparente 35 peut être mise en place sur l'ensemble porté par le substrat 20 alors que ce dernier est encore en forme de tranche (6 ou 8 pouces de diamètre par exemple) portant de nombreux capteurs d'image individuels.

Les figures 4 à 7 représentent diverses manières pour établir des contacts entre le capteur et l'extérieur, pour amener par exemple des signaux de commande et une énergie d'alimentation, et pour recueillir les signaux électroniques représentant l'image détectée par le capteur. Ces contacts sont réalisés là encore pendant qu'on travaille sur tranche, avant division de la tranche en capteurs individuels.

Dans la réalisation de la figure 4, on a créé dans la face avant de la tranche de silicium (face tournée vers le bas sur la figure 4), avant report sur la tranche de support, des puits d'accès 50 s'étendant jusqu'à une profondeur de 3 à 20. micromètres au-dessous de la surface initiale du silicium, et s'étendant plus précisément exactement jusqu'à la profondeur à laquelle on amincira la tranche de silicium.

Les puits d'accès ainsi creusés se situent à la périphérie de chaque capteur individuel, la zone matricielle active photosensible ZA étant entourée par la série de puits 50 (qui peuvent être typiquement au nombre de 30 ou 40 pour un capteur d'image individuel). Les puits 50 sont remplis d'un matériau conducteur 52 (aluminium, cuivre, tungstène, etc.) qui vient en contact, à la surface supérieure de la tranche de silicium (face tournée vers le bas, en contact avec le substrat de report 20), avec une ou plusieurs des couches conductrices 14, plus précisément avec celles qui nécessitent un contact avec l'extérieur. Avant remplissage des puits par le matériau conducteur, il est préférable de déposer une couche isolante (non représentée) sur les parois intérieures du puits, pour isoler les contacts de la couche de silicium 30.

Lors de l'amincissement du silicium après report, on élimine la majeure partie de l'épaisseur du silicium jusqu'à ce que le métal 52 des puits 50 affleure sur la surface en cours d'amincissement. Ce métal est alors utilisable soit directement soit après des opérations supplémentaires de dépôt et gravure, pour constituer des plages de contact vers l'extérieur. On peut y fixer des fils de soudure 54 (wire-bonding) en vue du report du capteur face arrière contre une carte de circuit imprimé, ou au contraire des bossages conducteurs (par exemple des billes d'indium 56) en vue d'un report du capteur face avant contre une carte de circuit imprimée (technique "flip-chip"). Dans ce dernier cas évidemment la carte de circuit imprimé est ouverte à l'endroit de la matrice photosensible pour laisser passer la lumière. La version à fils 54 et la version à bossages 56 sont représentées sur la même figure 4 mais évidemment une seule version doit être utilisée dans le même capteur.

Les filtres colorés 18 sont mis en place après amincissement de la tranche de silicium.

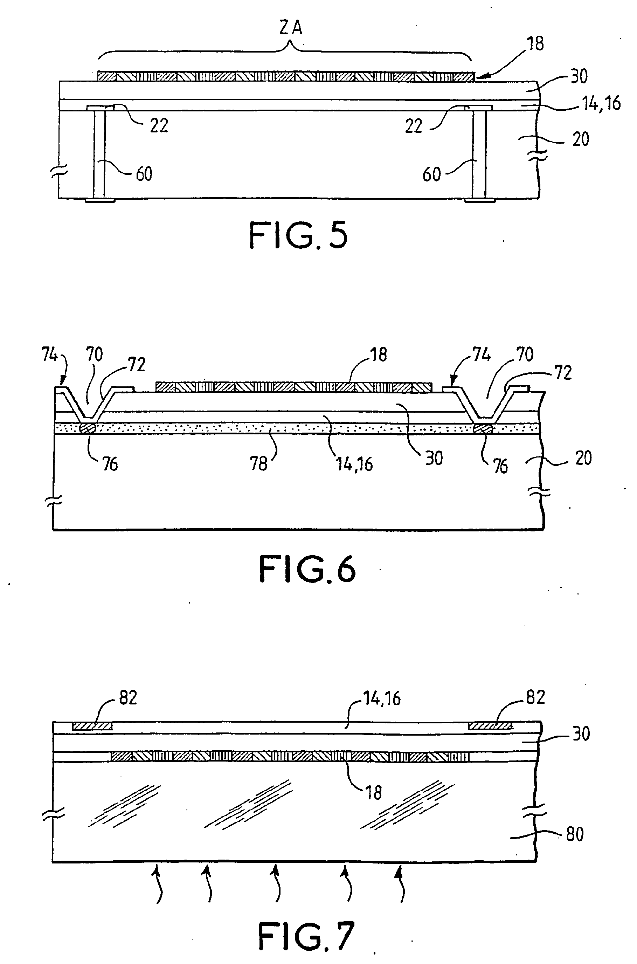

La figure 5 représente une autre réalisation pour réaliser des contacts de connexion avec l'extérieur. Dans cette réalisation, la tranche de support 20 sur laquelle on vient reporter la tranche de silicium a été préalablement préparée par formation de vias conducteurs 60 traversant toute l'épaisseur du support. Ces vias débouchent sur les deux faces de la tranche de support et ils sont disposés exactement en regard de plots de connexion 22 formés sur la face avant de la tranche de silicium à la périphérie de la zone active ZA de chaque capteur d'image individuel.

Lors du report de la tranche de silicium sur la tranche de support, le contact est ainsi fait entre les vias conducteurs 60 et les circuits de détection d'image de la tranche de silicium.

Les vias conducteurs qui débouchent à l'arrière de la tranche de support 20 permettent toutes sortes de connexion avec l'extérieur, wire-bonding, flip-chip ou autres.

On notera que la connexion est faite alors qu'on travaille encore sur tranche de silicium et qu'on peut faire un test des capteurs d'image sur tranche (test sous pointes), ce qui est très avantageux du point de vue du coût du test. Cette remarque s'applique également aux autres modes de connexion décrits ici (figure 4, 6, 7).

La figure 6 décrit une réalisation dans laquelle le contact est réalisé grâce aux opérations suivantes : après amincissement de la tranche de silicium, des puits d'accès 70 sont réalisés non seulement dans la couche de silicium aminci 30 mais aussi dans certaines des couches isolantes 16, jusqu'à faire affleurer le métal conducteur d'une couche conductrice 14 avec laquelle on veut effectuer une connexion vers l'extérieur. On métallise ensuite ces puits 70 par dépôt d'une couche conductrice 72 qui vient en contact avec la couche 14 et qui affleure à la surface de la couche de silicium aminci 30 pour former des plots de contact extérieur 74.

De plus, dans la réalisation de la figure 6, on peut prévoir également que l'opération de report de la tranche de silicium sur la tranche de support 20 se fait par une soudure, de préférence à travers des bossages conducteurs 76 (billes d'indium par exemple), entre des plages conductrices d'une couche 14 de la tranche de silicium, et des plages conductrices en regard des premières, formées dans la tranche de support 20. De préférence, une résine de remplissage 78 remplit l'espace laissé libre entre les deux tranches séparées par l'épaisseur des bossages. Cette résine assure la rigidité de la tranche pendant et après l'amincissement.

On notera que dans les réalisations des figures 4 à 6 le substrat de support 20 peut comprendre des éléments de circuit actifs ou passifs, en particulier dans le cas où ce substrat est en silicium : des circuits intégrés peuvent être formés dans ce substrat selon la technologie classique de fabrication de circuits intégrés, permettant d'intégrer dans le capteur d'image des fonctions électroniques supplémentaires autres que celles qui sont intégrées dans la couche de silicium 30.

La figure 7 représente une variante de réalisation présentant les particularités suivantes : les filtres colorés 18, la couche de silicium aminci 30 et l'empilement de couches conductrices et isolantes 14 sont disposés dans cet ordre sur un substrat transparent (verre ou matière plastique) 80. L'image à détecter sera vue à travers le substrat transparent et passera d'abord à travers les filtres colorés pour atteindre les zones photosensibles de la couche de silicium aminci 30 ; les photons de couleur correspondant aux filtres traversés seront absorbés dans la couche 30 ; seuls les photons non absorbés pourront atteindre l'empilement de couches isolantes et conductrices 14, 16.

Des plots de connexion 82, réalisés par dépôt de métal et gravure, et faisant partie d'une couche 14 ou étant en contact avec une couche 14, sont prévus sur la face supérieure de l'ensemble (vers le haut sur la figure 7).

Pour réaliser cette structure, il faut comprendre que l'on procède avec un premier report de la tranche de silicium sur une tranche de support 20, comme dans la réalisation de la figure 2, puis avec un deuxième report de la structure de la figure 2 sur un substrat transparent 80 et une suppression totale ou partielle de la tranche de support 20 qui n'a servi que de support provisoire.

Pour cela, à partir de la structure de la figure 2, réalisée comme on l'a déjà décrit, on planarise si nécessaire la surface supérieure portant les filtres colorés, pour lui donner une planéité compatible avec un nouveau report (en particulier une très bonne planéité si le report se fait par adhésion moléculaire). La résine de planarisation doit être transparente car elle sera sur le trajet de la lumière en amont des zones photosensibles.

On effectue ensuite le report de la structure ainsi planarisée sur le substrat 80, les filtres colorés ou la couche de planarisation étant en contact direct avec le substrat transparent 80. On élimine la majeure partie ou même la totalité du substrat 20 par des moyens mécaniques et/ou chimiques, ou par fragilisation par implantation d'hydrogène par exemple comme déjà expliqué. Dans ce cas, l'implantation d'hydrogène dans la tranche de support 20 doit avoir été faite préalablement au premier report de la tranche de silicium sur la tranche 20, ce qui suppose qu'entre le report sur la tranche 20 et le report sur le substrat 80 il n'y a pas d'opération à des températures susceptibles de provoquer la rupture au niveau du plan d'implantation d'hydrogène.

Le substrat provisoire 20 étant éliminé, des plots de connexion 82 reliés aux couches conductrices 14 des circuits de détection d'image peuvent affleurer à la surface de la structure de la figure 7.

Les figures 8 à 12 décrivent le détail de réalisation dans le cas du capteur de la figure 5.

Sur la figure 8, on voit la structure générale d'une tranche de silicium sur laquelle on a réalisé par des techniques classiques les circuits de détection d'image d'une multiplicité de capteurs d'image, avec des zones photosensibles 12, recouvertes d'un empilement de couches conductrices 14 et isolantes 16.

Des plots de connexion 22 sont réalisés sur la face supérieure de la tranche.

Si le capteur était réalisé avec une technologie classique, on déposerait alors à la surface de la tranche une mosaïque de filtres colorés.

Selon l'invention, on ne dépose pas de filtres colorés à ce stade mais on reporte la tranche par sa face avant sur un substrat de report 20 qui est représenté à la figure 9.

Le substrat 20 est une tranche de même diamètre que la tranche 10 et d'épaisseur analogue pour assurer la rigidité de la structure pendant la fabrication ; il peut d'ailleurs être constitué par une autre tranche de silicium.

Le substrat de report comporte des vias métallisés 60, traversant toute son épaisseur, disposés avec la même géométrie que les plots d'entrée/sortie 22 formés sur la tranche de silicium 10.

A la partie supérieure de chaque via métallisé on trouvera une plage conductrice 62 susceptible de venir en contact directement avec un plot 22 de la tranche 10 lors du report de la tranche 10 sur le substrat 20. A la partie inférieure de chaque via métallisé, on aura également une plage métallisée 64.

Le report peut être effectué après dépôt d'une couche de "planarisation" servant à combler les reliefs créés sur la face avant de la tranche de silicium par les opérations de dépôt et gravure de l'empilement de couches conductrices et isolantes. Cette couche de planarisation n'a pas besoin d'être transparente. Elle doit laisser libre la surface supérieure des plots conducteurs 22.

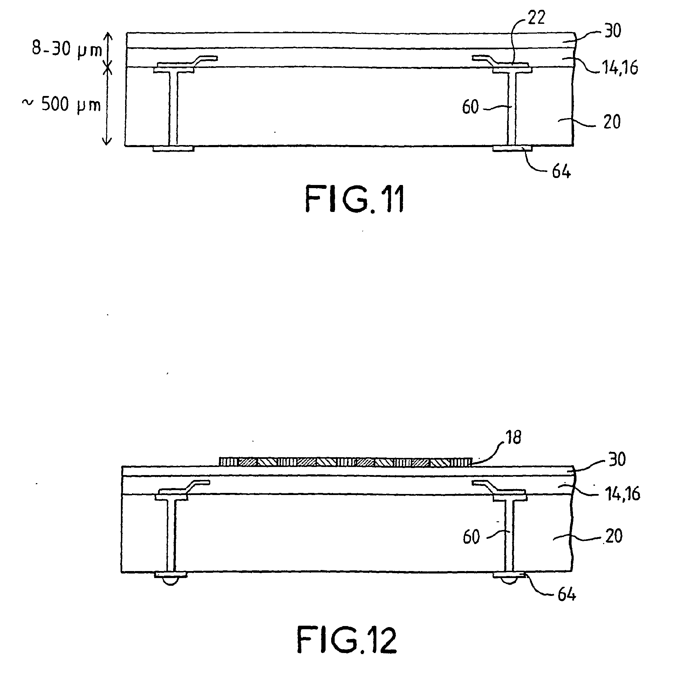

La figure 10 représente la tranche 10, retournée face supérieure vers le bas, en contact par cette face supérieure avec la face supérieure du substrat de report 20.

Le report se fait par collage ou par adhérence moléculaire. Il peut même se faire par soudure des plots 22 sur les plages 62.

Après ce report, on procède à l'amincissement de la tranche de silicium jusqu'à ne laisser subsister qu'une épaisseur de 15 à 30 micromètres, incluant l'épaisseur de l'empilement de couches 14, 16. L'épaisseur de silicium subsistante 30 et l'empilement de couches 14, 16 contiennent tous les circuits de détection d'image (Fig.11).

Enfin, on dépose sur la couche de silicium 30 ainsi amincie une mosaïque de filtres colorés et éventuellement aussi un film transparent, voire des microlentilles (Fig. 12).

Les plages métallisées 64 situées à l'arrière du substrat de support 20 servent de plots d'entrée/sortie du capteur puisqu'elles sont électriquement reliées aux circuits de détection d'image formés dans la tranche de silicium amincie 30. Ces plots peuvent être utilisés pour une connexion de type « wire-bonding» (à fils soudés) ou de préférence de type « flip-chip » (puce retournée). Dans ce dernier cas, on forme des bossages conducteurs 66 à la surface des plages 64.

La structure peut alors être testée (les capteurs sont fonctionnels) puis découpée en capteurs d'image individuels.

## Revendications

1. Procédé de fabrication d'un capteur d'image en couleur, comprenant :
- la formation, sur la face avant d'une tranche semiconductrice (10), d'une série de zones actives (ZA) comportant des circuits de détection d'image et correspondant chacune à un capteur d'image respectif, chaque zone active comprenant des zones photosensibles (12) recouvertes de couches conductrices (14) et isolantes (16) permettant le recueil de charges électriques générées dans les zones photosensibles,
- le report de la tranche (10) par sa face avant contre la face avant d'un substrat de support (20),
- l'élimination de la majeure partie de l'épaisseur de la tranche semiconductrice, laissant subsister sur le substrat une fine couche semiconductrice (30) comprenant les zones photosensibles, l'épaisseur de la tranche semiconductrice après amincissement étant d'environ 8 à 30 micromètres, incluant l'épaisseur de l'empilement de couches conductrices (14) et isolantes (16),
- et, ultérieurement, le dépôt et la gravure, sur la couche semiconductrice ainsi amincie, de filtres de couleur (18).

2. Procédé selon la revendication 1, **caractérisé en ce que** le report est fait par collage, par soudure, ou par simple adhérence moléculaire.

3. Procédé selon l'une des revendications 1 et 2, **caractérisé en ce qu**'on forme sur le substrat de support (20), préalablement au report de la tranche semiconductrice, des vias métallisés (60) disposés avec la même géométrie que des plots de connexion (22) formés sur la tranche semiconductrice autour de chaque zone active, et venant en contact avec ces derniers lors du report, les vias métallisés débouchant à l'arrière du substrat de support pour former des plots d'entrée/sortie (64) du capteur.

4. Capteur d'image comprenant, sur un substrat de support (20), un ensemble superposé comprenant d'une part une couche semiconductrice (30) dans laquelle on a formé un réseau matriciel de zones photosensibles (12) et d'autre part un empilement de couches gravées conductrices (14) et isolantes (16) permettant le recueil de charges électriques générées par la lumière dans chacune des zones photosensibles, **caractérisé par le fait que** des filtres de couleur sont déposés sur cet ensemble superposé, du côté de la couche semiconductrice, de manière que la lumière à détecter passe dans l'ordre à travers les filtres de couleur, puis dans les zones de silicium photosensibles, puis dans l'empilement de couches isolantes et conductrices, sans rencontrer un réseau des dites couches conductrices avant d'atteindre le réseau matriciel de zones photosensibles, la couche semiconductrice ayant une épaisseur d'environ 3 à 20 micromètres au-dessus de l'empilement de couches conductrices et isolantes.

5. Capteur selon la revendication 4, **caractérisé en ce que** le substrat de support comporte des éléments de circuit actifs ou passifs.

6. Capteur selon l'une des revendications 4 et 5, **caractérisé en ce que** la tranche semiconductrice et le substrat de support (20) sont en silicium.

7. Capteur selon l'une des revendications 4 à 6, **caractérisé en ce que** le substrat de support comporte des vias métalllisés (60) disposés avec la même géométrie que des plots de connexion (22) formés sur la tranche de silicium autour de chaque zone active, et venant en contact avec ces derniers lors du report, les vias métallisés débouchant à l'arrière du substrat de support pour former des plots d'entrée sortie (64) du capteur.

## Claims

1. Process for fabricating a colour image sensor comprising:
- the formation, on the front face of a semiconductor wafer (10), of a series of active zones (ZA) having image detection circuits and each corresponding to a respective image sensor, each active zone comprising photosensitive zones (12) covered with conducting (14) and insulating (16) layers, for collecting electrical charges generated in the photosensitive zones;
- the wafer (10) is bonded via its front face to the front face of a support substrate (20);
- most of the thickness of the semiconductor wafer is removed, leaving behind on the substrate a thin semiconductor layer (30) that includes the photosensitive zones, the thickness of the semiconductor wafer after thinning being about 8 to 30 microns, including the thickness of the stack of conducting (14) and insulating (16) layers; and, subsequently,
- the deposition and etching, on the semiconductor layer thus thinned, of colour filters (18).

2. Process according to Claim 1, **characterized in that** the bonding is performed by adhesive bonding, by welding or by simple wafer bonding (molecular adhesion).

3. Process according to either of Claims 1 and 2, **characterized in that**, prior to the bonding of the semiconductor wafer, plated vias (60) are formed in the support substrate (20), these being placed with the same geometry as connection pads (22) formed on the semiconductor wafer around each active zone, and coming into contact with them during bonding, the plated vias emerging at the rear of the support substrate to form input/output pads (64) for the sensor.

4. Image sensor comprising, on a support substrate (20), a superposed assembly comprising, on the one hand, a semiconductor layer (30) in which a matrix array of photosensitive zones (12) has been formed and, on the other hand, a stack of etched conducting (14) and insulating (16) layers, for receiving electrical charges generated by the light in each of the photosensitive zones, **characterized in that** colour filters are deposited on this superposed assembly, on the semiconductor layer side, so that the light to be detected passes, in order, through the colour filters, then through the photosensitive silicon zones and then through the stack of insulating and conducting layers, without encountering an array of said conducting layers, before reaching the matrix array of photosensitive zones, the semiconductor layer having a thickness of about 3 to 20 microns on top of the stack of conducting and insulating layers.

5. Sensor according to Claim 4, **characterized in that** the support substrate includes active or passive circuit elements.

6. Sensor according to either of Claims 4 and 5, **characterized in that** the semiconductor wafer and the support substrate (20) are made of silicon.

7. Sensor according to one of Claims 4 to 6, **characterized in that** the support substrate includes plated vias (60) placed with the same geometry as the connection pads (22) that are formed on the silicon wafer around each active zone, and coming into contact with the latter during bonding, the plated vias emerging at the rear of the support substrate to form input/output pads (64) for the sensor.

## Patentansprüche

1. Verfahren zur Herstellung eines Farbbildsensors, das aufweist:
- die Bildung einer Reihe von aktiven Zonen (ZA), die Bilderfassungsschaltungen aufweisen und je einem Bildsensor entsprechen, auf der Vorderseite einer Halbleiterscheibe (10), wobei jede aktive Zone fotoempfindliche Zonen (12) aufweist, die mit leitenden (14) und isolierenden Schichten (16) bedeckt sind, die das Auffangen von elektrischen Ladungen erlauben, die in den fotoempfindlichen Zonen erzeugt werden,
- den Übertrag der Scheibe (10) mit ihrer Vorderseite auf die Vorderseite eines Trägersubstrats (20),
- das Entfernen des größten Teils der Dicke der Halbleiterscheibe, wobei auf dem Substrat eine dünne Halbleiterschicht (30) gelassen wird, die die fotoempfindlichen Zonen enthält, wobei die Dicke der Halbleiterscheibe nach der Verdünnung etwa 8 bis 30 Mikrometer beträgt, einschließlich der Dicke der Stapelung von leitenden (14) und isolierenden Schichten (16),
- und später das Aufbringen und Ätzen auf die so verdünnte Halbleiterschicht von Farbfiltern (18).

2. Verfahren nach Anspruch 1, **dadurch gekennzeichnet, dass** der Übertrag durch Kleben, Schweißen oder einfaches molekulares Haften erfolgt.

3. Verfahren nach einem der Ansprüche 1 und 2, **dadurch gekennzeichnet, dass** auf dem Trägersubstrat (20) vor dem Übertrag der Halbleiterscheibe metallisierte Bohrungen (60) geformt werden, die mit der gleichen Geometrie angeordnet sind wie Anschlusskontakte (22), die auf der Halbleiterscheibe um jede aktive Zone herum geformt sind, und mit diesen letzteren beim Übertrag in Kontakt kommen, wobei die metallisierten Bohrungen an der Rückseite des Trägersubstrats münden, um Eingangs-/Ausgangsanschlusskontakte (64) des Sensors zu bilden.

4. Bildsensor, der auf einem Trägersubstrat (20) eine gestapelte Einheit aufweist, die einerseits eine Halbleiterschicht (30), in der ein Matrixgitter von fotoempfindlichen Zonen (12) geformt wurde, und andererseits eine Stapelung von geätzten leitenden (14) und isolierenden Schichten (16) aufweist, die das Auffangen von elektrischen Ladungen erlauben, die vom Licht in jeder der fotoempfindlichen Zonen erzeugt wurden, **dadurch gekennzeichnet, dass** Farbfilter auf diese gestapelte Einheit auf der Seite der Halbleiterschicht aufgebracht werden, damit das zu erfassende Licht in der Reihenfolge durch die Farbfilter, dann durch die fotoempfindlichen Siliciumzonen, dann durch den Stapel von isolierenden und leitenden Schichten geht, ohne auf ein Gitter der leitenden Schichten zu treffen, ehe es das Matrixgitter von fotoempfindlichen Zonen erreicht, wobei die Halbleiterschicht eine Dicke von etwa 3 bis 20 Mikrometern über der Stapelung von leitenden und isolierenden Schichten hat.

5. Sensor nach Anspruch 4, **dadurch gekennzeichnet, dass** das Trägersubstrat aktive oder passive Schaltungselemente aufweist.

6. Sensor nach einem der Ansprüche 4 und 5, **dadurch gekennzeichnet, dass** die Halbleiterscheibe und das Trägersubstrat (20) aus Silicium sind.

7. Sensor nach einem der Ansprüche 4 bis 6, **dadurch gekennzeichnet, dass** das Trägersubstrat metallisierte Bohrungen (60) aufweist, die mit der gleichen Geometrie angeordnet sind wie Anschlusskontakte (22), die auf der Siliciumscheibe um jede aktive Zone herum geformt sind, und mit diesen letzteren beim Übertrag in Kontakt kommen, wobei die metallisierten Bohrungen an der Rückseite des Trägersubstrats münden, um Eingangs-/Ausgangsanschlusskontakte (64) des Sensors zu bilden.
